(19) Europäisches Patentamt

European Patent Office

Office européen des brevets

(11) **EP 4 113 138 B1**

(12) **EUROPEAN PATENT SPECIFICATION**

(45) Date of publication and mention
of the grant of the patent:
**13.03.2024 Bulletin 2024/11**

(21) Application number: **21793367.0**

(22) Date of filing: **30.03.2021**

(51) International Patent Classification (IPC):
*G01R 31/34* (2020.01)     *G01R 31/12* (2020.01)
*G01M 13/04* (2019.01)     *B60L 3/00* (2019.01)
*B60L 3/12* (2006.01)     *B60L 15/02* (2006.01)

(52) Cooperative Patent Classification (CPC):
**G01R 31/343; B60L 3/0061; B60L 3/12;
B60L 15/025; G01M 13/04;** G01R 31/52

(86) International application number:
**PCT/CN2021/083885**

(87) International publication number:
**WO 2021/213142 (28.10.2021 Gazette 2021/43)**

(54) **TRACTION MOTOR FAULT DIAGNOSIS METHOD AND APPARATUS**

VERFAHREN UND VORRICHTUNG ZUR DIAGNOSE VON ZUGMOTORFEHLERN

PROCÉDÉ ET APPAREIL DE DIAGNOSTIC DE DÉFAUT DE MOTEUR DE TRACTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.04.2020 CN 202010327154**

(43) Date of publication of application:
**04.01.2023 Bulletin 2023/01**

(73) Proprietor: **CRRC Zhuzhou Electric Locomotive
Research
Institute Co., Ltd.
Zhuzhou, Hunan 412001 (CN)**

(72) Inventors:
• **FENG, Jianghua**
  **Zhuzhou, Hunan 412001 (CN)**
• **LIU, Yong**
  **Zhuzhou, Hunan 412001 (CN)**
• **XU, Hailong**
  **Zhuzhou, Hunan 412001 (CN)**
• **ZHU, Wenlong**
  **Zhuzhou, Hunan 412001 (CN)**
• **MEI, Wenqing**
  **Zhuzhou, Hunan 412001 (CN)**
• **DAI, Jisheng**
  **Zhuzhou, Hunan 412001 (CN)**

(74) Representative: **Frick, Robert
Lorenz Seidler Gossel
Rechtsanwälte Patentanwälte
Partnerschaft mbB
Widenmayerstraße 23
80538 München (DE)**

(56) References cited:
CN-A- 104 155 585     CN-A- 106 841 949
CN-A- 109 061 474     CN-A- 109 061 474
CN-A- 109 238 698     CN-A- 109 556 862
CN-A- 109 635 879     CN-A- 111 208 427
KR-A- 20190 118 339     US-A1- 2004 227 520

• KOU LINLIN ET AL: "An Integrated Model of kNN
and GBDT for Fault Diagnosis of Wheel on
Railway Vehicle", 2018 PROGNOSTICS AND
SYSTEM HEALTH MANAGEMENT CONFERENCE
(PHM-CHONGQING), IEEE, 26 October 2018
(2018-10-26), pages 432-436, XP033493902, DOI:
10.1109/PHM-CHONGQING.2018.00080
[retrieved on 2019-01-04]

**(Cont. next page)**

- JAFARI HAMIDEH ET AL: "Fault detection and isolation based on fuzzy-integral fusion approach", IET SCIENCE, MEASUREMENT AND TECHNOLOGY, THE INSTITUTION OF ENGINEERING AND TECHNOLOGY, MICHAEL FARADAY HOUSE, SIX HILLS WAY, STEVENAGE, HERTS. SG1 2AY, UK, vol. 13, no. 2, 1 March 2019 (2019-03-01), pages 296-302, XP006086562, ISSN: 1751-8822, DOI: 10.1049/IET-SMT.2018.5005
- Nykyri Mikko: "DATA ANALYTICS FOR PREDICTIVE MAINTENANCE IN A PULP MILL - CASE ELECTRIC MOTORS", , 1 January 2018 (2018-01-01), pages 1-48, XP093064836, Retrieved from the Internet: URL:https://lutpub.lut.fi/bitstream/handle /10024/158682/diplomity%c3%b6_nykyri_mikko .pdf?sequence=1&isAllowed=y [retrieved on 2023-07-18]
- Wang Shizheng, Guo Weiqin: "Fuzzy Expert System for Insulation Faults in Generators", Journal of Shanghai Second Polytechnic University, no. 1, 31 March 2000 (2000-03-31), pages 7-13, XP055859559, ISSN: 1001-4543, DOI: 10.19570/j.cnki.jsspu.2000.01.002

**Description**

**FIELD**

The present disclosure relates to the technical field of fault diagnosis on motors, and in particular to a fault diagnosis method and device for a traction motor.

**BACKGROUND**

With the wide application of rail trains, in electric railway rolling stock, a traction motor is a most core component for performing a conversion between electric energy and mechanical energy and outputting power during the operation of rolling stock, thereby having an important impact on the operation efficiency and safety of railway rolling stock. Based on the operation practice, it shows that the operation conditions of the traction motor of the rail train are complex and changeable. Affected by a vibration and impact of the rail surface, a high-frequency common mode voltage of an electric drive system of a PWM (Pulse Width Modulation) inverter, and an ambient temperature, a fault may easily occur in the traction motor. The fault of the traction motor may affect the traffic order, cause major economic losses, and even results in safety accident and endangers personal safety.

According to the survey results, 40% of faults of the traction motor are related to a bearing and 38% of the faults are related to insulation of a stator coil. Therefore, the fault diagnosis on the traction motor is mainly to diagnose the bearing and diagnose the insulation of the stator coil. At present, the fault diagnosis on the bearing of the traction motor is mainly performed based on a vibration signal analysis method and a temperature signal analysis method. However, in the vibration signal analysis method and the temperature signal analysis method, a vibration acceleration sensor, a temperature sensor and related analysis and diagnosis devices are required, thus the device maintenance costs are increased and faults may occur in the newly added devices themselves. For the stator coil of the traction motor, insulation fault diagnosis is performed by off-line regular inspection and maintenance. The inspection is time-consuming and laborious, and the insulation fault of the stator coil of the traction motor cannot be avoided during two regular inspections. According to CN109061474A, a motor bearing failure diagnosis device is disclosed. When the device is in a failure diagnosis state, a current signal acquisition unit obtains the motor current real-time signal. A residual signal acquisition unit conducts harmonic signal extraction on the motor current real-time signal obtained by the current signal acquisition unit, and base frequency and harmonic signals are eliminated from the original motor current signal to obtain the residual signal. According to document "An Integrated Model of kNN and GBDT for Fault Diagnosis of Wheel on Railway Vehicle", 2018 PROGNOSTICS AND SYSTEM HEALTH MANAGEMENT CONFERENCE (PHM-CHONGQING), IEEE, 26 October 2018 (2018-10-26), by Kou Linlin et al., an integrating algorithm with k-Nearest Neighbours (kNN) and gradient boosting decision tree (GBDT) is disclosed to deal with the typical imbalance and divergent characteristics and satisfy the high requirement of fault detection accuracy. According to document "Fault detection and isolation based on fuzzy-integral fusion approach", IET SCIENCE, MEASUREMENT AND TECHNOLOGY, THE INSTITUTION OF ENGINEERING AND TECHNOLOGY, MICHAEL FARADAY HOUSE, SIX HILLS WAY, STEVENAGE, HERTS. SG1 2AY, UK, vol. 13, no. 2,1 March 2019 (2019-03-01), by Jafari Hamideh et al., a bearing and an electric faults of an induction motor are diagnosed using the fuzzy-integral data-fusion method in feature level with high reliability. Time domain of various features is computed using the induction motor three-phase current and voltage measurements. Appropriate features are extracted by means of the proposed method and then classified by the fuzzy C-means algorithm. According to document "DATA ANALYTICS FOR PREDICTIVE MAINTENANCE IN A PULP MILL-CASE ELECTRIC MOTORS", 1 January 2018 (2018-01-01), pages 1-48, by Nykyri Mikko, capabilites of data analytics are studied by generating machine learning models. The model detects and predicts overloads on a pump motor. Additionally, a model for pulp production amount prediction was also generated.

**SUMMARY**

Based on the problems in the conventional fault diagnosis method for a traction motor, a fault diagnosis method for a traction motor as defined in claim 1 and a device for a traction motor as defined in claim 4 are provided according to the present disclosure. In the present disclosure, a traction motor of a train is taken as an object, an fault diagnosis is performed on a bearing of the traction motor and an insulation fault diagnosis is performed on a stator coil of the traction motor without adding sensors and performing device modification in a traction system of the train, thereby reducing the cost of the fault diagnosis of the traction motor.

In an embodiment, the predetermined gradient boosting tree model is constructed by: obtaining the sample data of the bearing; and training a gradient boosting tree model based on the sample data of the bearing by using a gradient boosting tree intelligent identification algorithm to construct the predetermined gradient boosting tree model for performing fault diagnosis and identification on the bearing of the traction motor.

In an embodiment, the predetermined fuzzy clustering model is constructed by: obtaining the insulation sample data of the stator coil; and training a fuzzy clustering model based on the insulation sample data of the stator coil by using a fuzzy clustering algorithm to construct the predetermined fuzzy clustering model for performing insulation fault diagnosis and identification on the stator coil of the traction motor.

A storage medium as defined in claim 5 is provided according to the present disclosure. The storage medium stores a program. The program, when executed, causes a device where the storage medium is located to perform the fault diagnosis method for a traction motor.

An electronic device as defined in claim 6 is provided according to the present disclosure. The electronic device includes at least one processor, at least one memory connected to the processor, and a bus. The processor communicates with the memory via the bus. The processor is configured to call program instructions stored in the memory to perform the fault diagnosis method for a traction motor.

In the present disclosure, without adding sensors and performing device modification in a traction system of the train, the traction motor of the train is taken as the object, a predetermined gradient boosting tree model is called based on the fault diagnosis parameters of the bearing of the traction motor to perform fault diagnosis on the bearing of the traction motor, and a predetermined fuzzy clustering model is called based on the insulation fault diagnosis parameters of the stator coil of the traction motor to perform insulation fault diagnosis on the stator coil of the traction motor, thereby reducing the cost of the fault diagnosis of the traction motor.

**BRIEF DESCRIPTION OF THE DRAWINGS**

In order to illustrate technical solutions in embodiments of the present disclosure or the conventional technology more clearly, drawings to be used in the description of the embodiments or the conventional technology are introduced simply hereinafter.

Figure 1 is a schematic diagram of a fault diagnosis system for a traction motor according to an embodiment of the present disclosure;
Figure 2 is a flow chart of a fault diagnosis method for a traction motor according to an embodiment of the present disclosure;
Figure 3 is a flow chart of an implementation of obtaining a fault harmonic pulse spectrum index in a step S202 according to an embodiment of the present disclosure;
Figure 4 is a flow chart of an implementation of constructing a predetermined gradient boosting tree model in a step S202 according to an embodiment of the present disclosure;
Figure 5 is a flow chart of an implementation of obtaining a dimension-reduced eigenvector in a step S203 according to an embodiment of the present disclosure;
Figure 6 is a flow chart of an implementation of extracting a multi-dimension eigenvector in a motor control signal and performing dimension reduction on the multi-dimension eigenvector to obtain a dimension-reduced eigenvector in a step S502 according to an embodiment of the present disclosure;
Figure 7 is a flow chart of an implementation of performing dimension reduction on a first eigenvector, a second eigenvector and a third eigenvector to obtain a dimension-reduced eigenvector in a step S604 according to an embodiment of the present disclosure;
Figure 8 is a flow chart of an implementation of constructing a predetermined fuzzy clustering model in a step S203 according to an embodiment of the present disclosure;
Figure 9 is a schematic structural diagram of a fault diagnosis device for a traction motor according to an embodiment of the present disclosure; and
Figure 10 is schematic structural diagram of an electronic device according to an embodiment of the present disclosure.

**DETAILED DESCRIPTION**

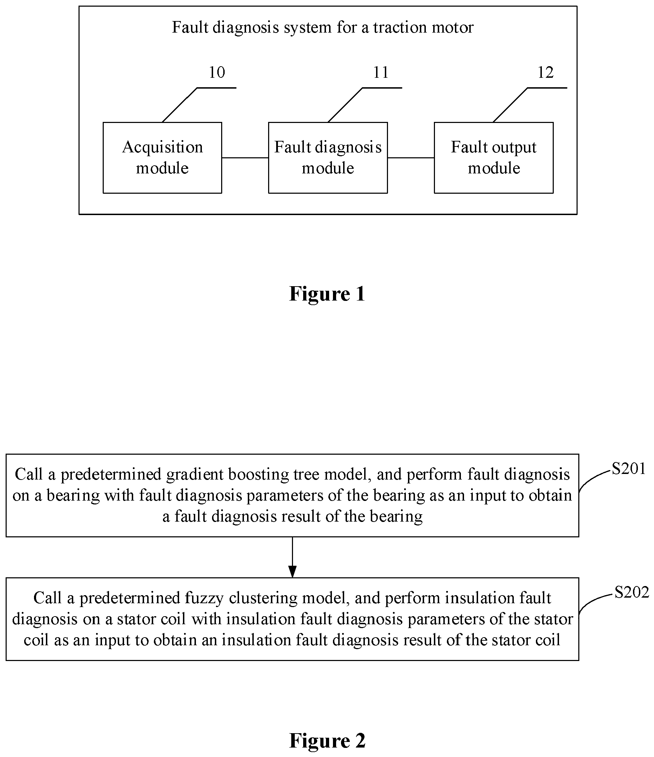

A fault diagnosis method and device for a traction motor are provided according to the present disclosure, which are applied to a fault diagnosis module in a fault diagnosis system for the traction motor as shown in Figure 1. The fault diagnosis system for the traction motor includes an acquisition module 10, a fault diagnosis module 11 and a fault output module 12. The acquisition module 10 is configured to acquire fault diagnosis parameters of a bearing and insulation fault diagnosis parameters of a stator coil in real time. The fault diagnosis parameters of the bearing include a fault harmonic pulse spectrum index, a motor speed, a motor torque and a current signal. The insulation fault diagnosis parameters of the stator coil include a dimension-reduced eigenvector, the motor speed and the motor torque. The fault diagnosis module 11 is configured to call a predetermined gradient boosting tree model to perform fault diagnosis on the bearing of the traction motor and call a predetermined fuzzy clustering model to perform insulation fault diagnosis on the stator coil of the traction motor. The fault output module 12 is configured to output fault diagnosis results. A fault diagnosis result of the bearing of the traction motor includes: a result indicating a bearing outer ring fault, a result indicating a bearing inner ring fault, a result indicating a bearing rolling element fault, a result indicating a bearing cage fault, and a result indicating a normal bearing. An insulation fault diagnosis result of the stator coil includes: a result indicating a stator coil insulation early fault, a result indicating a stator coil insulation serious fault, and a result indicating a stator coil normal insulation.

In the fault diagnosis method and device for a traction motor according to the present disclosure, a traction motor of a train is taken as an object, and an fault diagnosis is performed on a bearing of the traction motor and an insulation fault diagnosis is performed on a stator coil of the traction motor without adding sensors and performing device modification in a traction system of the train, thereby reducing the cost of the fault diagnosis of the traction motor.

The technical solutions according to the embodiments of the present disclosure are described clearly and completely as follows in conjunction with the drawings in the embodiments of the present disclosure. It is apparent that the described embodiments are only some embodiments of the present disclosure, rather than all embodiments. Any other embodiments obtained by those skilled in the art based on the embodiments in the present disclosure without any creative work fall within the protection scope of the present disclosure.

Reference is made to Figure 2, which is a flow chart of a fault diagnosis method for a traction motor according to an embodiment of the present disclosure. The method is applied to a fault diagnosis system for the traction motor. The method includes the following steps S201 and 5202.

In step S201, a predetermined gradient boosting tree model is called, and fault diagnosis is performed on a bearing with fault diagnosis parameters of the bearing as an input to obtain a fault diagnosis result of the bearing.

The predetermined gradient boosting tree model is constructed based on sample data of the bearing. The sample data of the bearing includes fault diagnosis parameters of the bearing respectively in a normal state, in an outer ring fault state, in an inner ring fault state, in a rolling element fault state and in a cage fault state. The fault diagnosis parameters of the bearing include a fault harmonic pulse spectrum index, a motor speed, a motor torque, and a current signal. The fault harmonic pulse spectrum index indicates a fault state of the bearing of the traction motor.

In an embodiment of the present disclosure, the fault diagnosis result of the bearing includes at least one of a result indicating a bearing outer ring fault, a result indicating a bearing inner ring fault, a result indicating a bearing rolling element fault, a result indicating a bearing cage fault, and a result indicating a normal bearing.

It should be noted that in a case that a bearing fault occurs in the traction motor, a rolling element of the bearing passing a fault point may cause a radial displacement of a rotor of an induction motor, resulting in a change in an air gap length of the induction motor. The change affects the motor torque and the motor speed, and causes a periodic harmonic pulse to be generated in the motor torque and the motor speed. That is, in the case that the bearing fault occurs in the traction motor, a harmonic component reflecting the bearing fault is generated in the motor speed and the motor torque. A frequency of the harmonic component is calculated by using the following equation:

$$ f_{error} = \left| f_s \pm f_r \pm k f_c \right| $$

where, $f_{error}$ represents a fault harmonic pulse frequency in the motor torque and the motor speed due to the bearing fault, $f_s$ represents a fundamental frequency of a current of the motor, $f_r$ represents a rotation frequency of the motor, $f_c$ represents a pass frequency of a bearing inner ring, a bearing outer ring, a bearing rolling element or a bearing cage, and k represents a positive integer and generally is set to 1, 2 or 3.

Therefore, in the case that the bearing fault occurs in the traction motor, feature frequencies of the motor torque and the motor speed corresponding to different fault types of the bearing may be obtained, thereby performing fault diagnosis on the bearing of the traction motor.

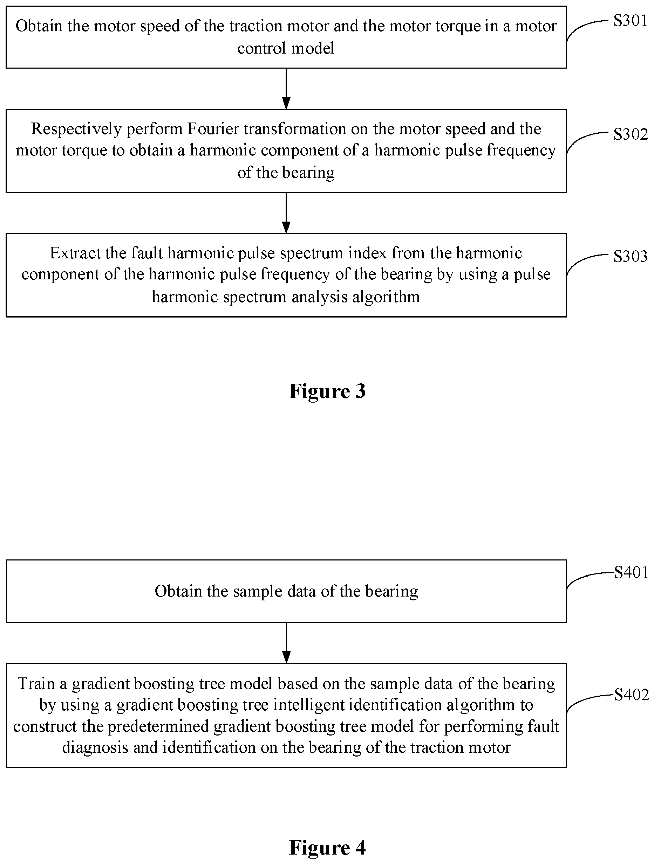

As shown in Figure 3, the fault harmonic pulse spectrum index may be obtained by performing the following steps S301 to S303.

In step S301, a motor speed of the traction motor and a motor torque in a motor control model are obtained.

In step S302, Fourier transformation is respectively performed on the motor speed and the motor torque to obtain a harmonic component of a harmonic pulse frequency of the bearing.

It should be noted that the process of performing Fourier transformation on the motor speed and the motor torque is one of technical means commonly used by those skilled in the art. The specific transformation process may refer to related technical documents, and is not described in detail herein.

In step S303, the fault harmonic pulse spectrum index is extracted from the harmonic component of the harmonic pulse frequency of the bearing by using a pulse harmonic spectrum analysis algorithm.

After the fault harmonic pulse spectrum index is obtained, fault diagnosis is performed on the bearing of the traction motor by using a gradient boosting tree intelligent identification algorithm with the fault harmonic pulse spectrum index, the motor speed, the motor torque and the current signal as an input vector.

The gradient boosting tree intelligent identification algorithm is one of technical means commonly used by those skilled in the art, having the advantages of training and analyzing quickly and achieving accurate results, and thereby meeting the requirements of the fault diagnosis on the bearing of the traction motor.

It should be noted that the predetermined gradient boosting tree model is constructed based on sample data of the bearing. The sample data of the bearing includes fault diagnosis parameters of the bearing respectively in a normal state, in an outer ring fault state, in an inner ring fault state, in a rolling element fault state and in a cage fault state. The fault diagnosis parameters of the bearing include the fault harmonic pulse spectrum index, the motor speed, the motor torque and the current signal. The fault harmonic pulse spectrum index indicates a fault state of the bearing of the traction motor.

As shown in Figure 4, the predetermined gradient boosting tree model is constructed by performing the following steps S401 to S402.

In step S401, the sample data of the bearing is obtained.

In step S402, a gradient boosting tree model is trained based on the sample data of the bearing by using a gradient boosting tree intelligent identification algorithm to construct the predetermined gradient boosting tree model for performing fault diagnosis and identification on the bearing of the traction motor.

Before performing fault diagnosis, a gradient boosting tree model is trained based on a large number of sample data of the bearing in a normal state and in fault states (including an outer ring fault state, an inner ring fault state, a rolling element fault state and a cage fault state) to construct the predetermined gradient boosting tree model for performing fault diagnosis and identification on the bearing of the traction motor. Then, the fault harmonic pulse spectrum index obtained by the motor in real time, the motor speed, the motor torque, and the current signal are inputted to the trained predetermined gradient boosting tree model to perform accurate fault diagnosis and identification on the bearing of the traction motor.

It should be noted that in the embodiments of the present disclosure, the gradient boosting tree intelligent algorithm for performing fault diagnosis on the bearing of the traction motor may be replaced by an artificial intelligence algorithm such as a neural network, a random forest and a support vector machine, or diagnosis rule based on expert knowledge.

In step S202, a predetermined fuzzy clustering model is called, and insulation fault diagnosis is performed on a stator coil with insulation fault diagnosis parameters of the stator coil as an input to obtain an insulation fault diagnosis result of the stator coil.

In the step S202, the predetermined fuzzy clustering model is constructed based on insulation sample data of the stator coil. The insulation sample data of the stator coil includes insulation fault diagnosis parameters of the stator coil respectively in an insulation early fault state, in an insulation serious fault state and in an insulation normal state. The insulation fault diagnosis parameters of the stator coil include dimension-reduced eigenvector, the motor speed and the motor torque. The dimension-reduced eigenvector indicates an insulation fault state of the stator coil of the traction motor.

It should be noted that the insulation early fault state of the stator coil is a state in which an insulation fault just occurs in the stator coil of the traction motor. In a case that an insulation early stator coil fault occurs in the traction motor, that is, the traction motor operates in the insulation early fault state of the stator coil, the traction motor may normally operate, and it is required to repair or replace the traction motor in time. The insulation serious fault state of the stator coil is a state in which a short-circuit fault or an open-circuit fault has occurred in the stator coil of the traction motor. In a case that an insulation serious fault occurs in stator coil of the traction motor, that is, the traction motor operates in the insulation serious fault state of the stator coil, the traction motor cannot normally operate, and it is required to perform replacement in time. Untimely replacement may affect the traffic order, cause major economic losses, and even results in safety accident and endangers personal safety.

In a case that an insulation fault occurs in the stator coil of the traction motor, parameters of the stator coil of the traction motor changes accordingly, resulting in a specific change trend in a motor control signal. Therefore, in the embodiments of the present disclosure, insulation fault diagnosis is performed on the stator coil based on the motor control signal by using a fusion analysis algorithm.

Specifically, the motor control signal may include the voltage signal, the current signal, the motor speed, and the motor torque in the motor control model of the traction motor. First, fault features are extracted by using a spectrum analysis algorithm, a Park vector analysis algorithm and a symmetrical component analysis algorithm to obtain a multi-dimension eigenvector. Then, dimension reduction is performed on the obtained multi-dimension eigenvector by using a principal component analysis algorithm to obtain a dimension-reduced eigenvector. Finally, state identification is performed on the insulation of the stator coil of the traction motor based on the dimension-reduced eigenvector and state parameters such as the motor speed and the motor torque by using a fuzzy clustering algorithm, thereby performing insulation fault diagnosis and identification on the stator coil of the traction motor. It should be noted that in the embodiments of the present disclosure, the insulation fault diagnosis result of the stator coil is one of a result indicating a stator coil insulation early fault, a result indicating a stator coil insulation serious fault, and a result indicating a stator coil normal insulation.

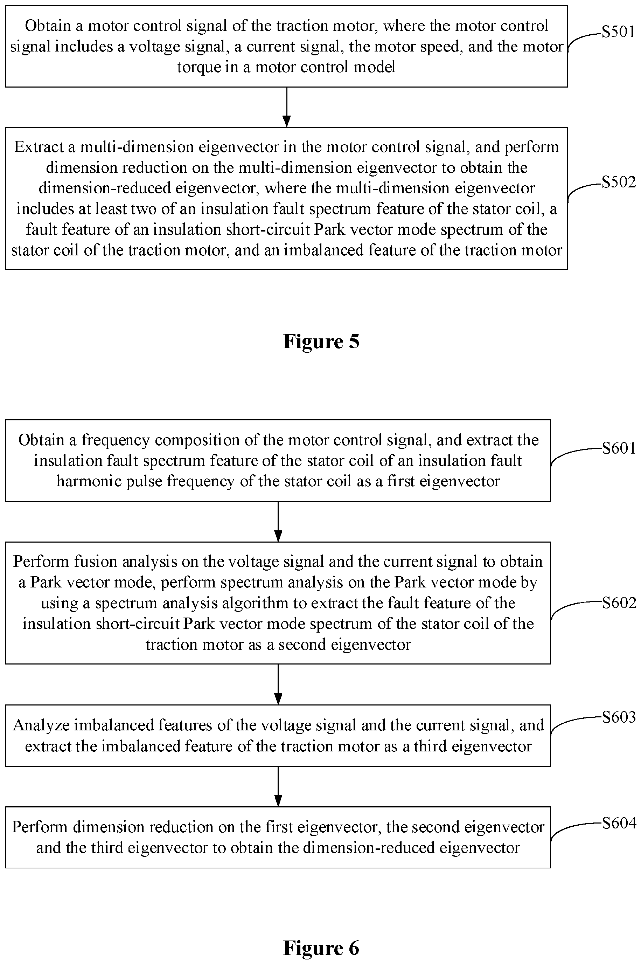

As shown in Figure 5, the dimension-reduced eigenvector may obtained by performing the following steps S501 and S502.

In step S501, a motor control signal of the traction motor is obtained. The motor control signal includes a voltage signal, the current signal, the motor speed, and the motor torque in a motor control model.

In step S502, a multi-dimension eigenvector in the motor control signal is extracted, and dimension reduction is performed on the multi-dimension eigenvector to obtain the dimension-reduced eigenvector. The multi-dimension eigenvector includes at least two of an insulation fault spectrum feature of the stator coil, a fault feature of an insulation short-circuit Park vector mode spectrum of the stator coil of the traction motor, and an imbalanced feature of the traction motor.

As shown in Figure 6, the process of extracting a multi-dimension eigenvector in the motor control signal and performing dimension reduction on the multi-dimension eigenvector to obtain the dimension-reduced eigenvector may include the following steps S601 to S604.

In step S601, a frequency composition of the motor control signal is obtained, and the insulation fault spectrum feature of the stator coil of an insulation fault harmonic pulse frequency of the stator coil is extracted as a first eigenvector.

The frequency composition of the motor control signal is obtained by using a spectrum analysis algorithm. In a case that an insulation fault occurs in the stator coil of the traction motor, the insulation fault spectrum feature of the stator coil of the insulation fault harmonic pulse frequency of the stator coil is extracted, and the insulation fault spectrum feature of the stator coil is determined as the first eigenvector.

In step S602, fusion analysis is performed on the voltage signal and the current signal to obtain a Park vector mode, and spectrum analysis is performed on the Park vector mode by using the spectrum analysis algorithm to extract the fault feature of the insulation short-circuit Park vector mode spectrum of the stator coil of the traction motor as a second eigenvector.

First, fusion analysis is performed on the three-phase voltage signal and the current signal of the traction motor by using a Park vector mode analysis algorithm to obtain the vector mode. Then, spectrum analysis is performed on the vector mode to extract the fault feature of the insulation short-circuit Park vector mode spectrum of the stator coil of the traction motor, and the fault feature is determined as the second eigenvector.

In step S603, imbalanced features of the voltage signal and the current signal are analyzed, and the imbalanced feature of the traction motor is extracted as a third eigenvector.

In actual operations, since three-phase windings of the traction motor are symmetrical, an unbalance degree of the traction motor is almost zero. In a case that an insulation fault occurs in the stator coil of the traction motor, the unbalance degree of the traction motor increases. Therefore, it is required to analyze the imbalanced features of the voltage signal and the current signal of the traction motor by using a symmetrical component analysis algorithm and extract the imbalanced feature of the traction motor. The imbalanced feature is determined as the third eigenvector.

In step S604, dimension reduction is performed on the first eigenvector, the second eigenvector and the third eigenvector to obtain the dimension-reduced eigenvector.

In an embodiment of the present disclosure, dimension reduction is performed on the first eigenvector, the second eigenvector and the third eigenvector by using a principal component analysis algorithm to obtain the dimension-reduced eigenvector.

The principal component analysis algorithm, also known as principal component analysis, is a data statistical dimension reduction algorithm. In the algorithm, multiple indicators are converted to a few comprehensive indicators (that is, principal components) based on an idea of dimension reduction. Each of the principal components may reflect most of information of original variables, and the information corresponding to the principal components is not repeated. With the algorithm, multiple variables are introduced and complex factors are reduced to several principal components, simplifying problems and achieving scientific and effective data information.

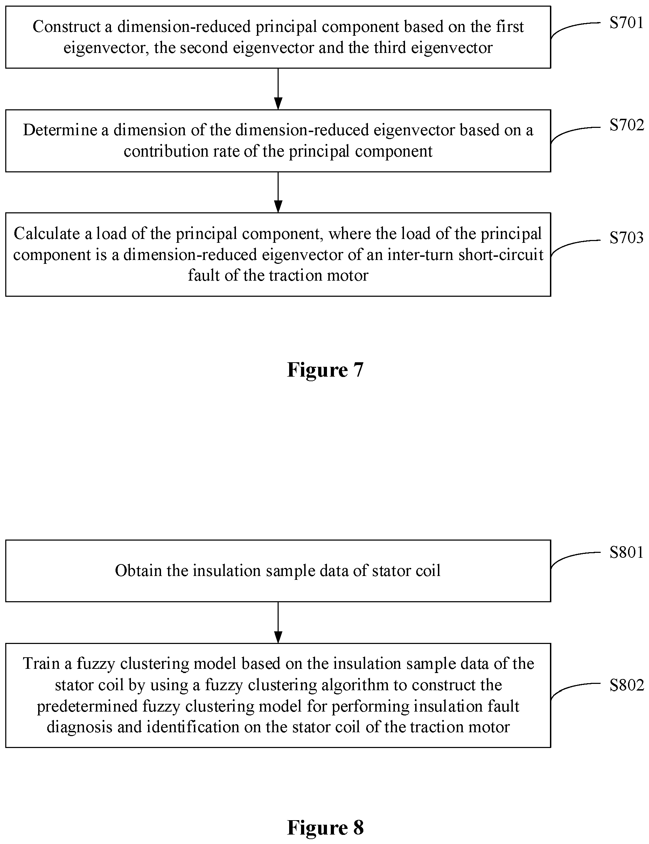

As shown in Figure 7, the process of performing dimension reduction on the first eigenvector, the second eigenvector and the third eigenvector to obtain the dimension-reduced eigenvector includes the following steps S701 to S703.

In step S701, a dimension-reduced principal component is constructed according to the first eigenvector, the second eigenvector and the third eigenvector.

The dimension-reduced principal component is calculated by using the following equation:

$$F_i = a_{i1}X_1 + a_{i2}X_2 + a_{i3}X_3$$

where $F_i$ represents the dimension-reduced eigenvector, $X_1$ represents the first eigenvector, $X_2$ represents the second eigenvector, $X_3$ represents the third eigenvector, $a_{i1}$, $a_{i2}$, and $a_{i3}$ represent eigenvalues of an eigenvector matrix $[X_1,$

$X_2$, $X_3$].

In step S702, a dimension of the dimension-reduced eigenvector is determined based on a contribution rate of the principal component.

In step S703, a load of the principal component is calculated. The load of the principal component is a dimension-reduced eigenvector of an inter-turn short-circuit fault of the traction motor.

The load of the principal component is calculated by using the following equation:

$$P(Z_k, x_i) = \sqrt{\lambda_k a_{ki}} \, (i = 1,2,3, \quad k = 1,2,..., \quad m)$$

where $P_{ki}$ represents the load of the principal component and is the dimension-reduced eigenvector of the inter-turn short-circuit fault of the traction motor, $P$ represents the load of the principal component, $\lambda_k$ represents a contribution rate of a principal component of a dimension-reduced eigenvector $F_i$, and m represents the dimension of the dimension-reduced eigenvector.

It should be noted that $P_{ki}$, calculated by using the above equation, represents the dimension-reduced eigenvector of the inter-turn short-circuit fault of the traction motor. With the dimension-reduced eigenvector, the dimension of the eigenvector matrix is obviously reduced, and the efficiency of the insulation fault diagnosis on the stator coil is improved.

It should be noted that in the embodiments of the present disclosure, in the insulation fault diagnosis on the stator coil of the traction motor, dimension reduction is performed on the multi-dimension eigenvector by using the principal component analysis algorithm, and a linear discriminant analysis algorithm may be used.

After obtaining the dimension-reduced eigenvector, insulation fault diagnosis is performed on a stator coil by using a fuzzy clustering algorithm with the dimension-reduced eigenvector, the motor speed and the motor torque as an input.

The fuzzy clustering algorithm is one of technical means commonly used by those skilled in the art, having the advantages of training and analyzing quickly and achieving accurate results, and thereby meeting the requirements of the insulation fault diagnosis on the stator coil.

It should be noted that the predetermined fuzzy clustering model is constructed based on insulation fault sample data of the stator coil. The insulation fault sample data of the stator coil includes dimension-reduced eigenvectors respectively corresponding to a stator coil insulation early fault, a stator coil insulation serious fault and a stator coil normal insulation, the motor speed, and the motor torque.

As shown in Figure 8, the predetermined fuzzy clustering model is constructed by performing the following steps S801 and S802.

In step S801, the s insulation ample data of the stator coil is obtained.

In step S802, a fuzzy clustering model is trained based on the insulation sample data of the stator coil by using a fuzzy clustering algorithm to construct the predetermined fuzzy clustering model for performing insulation fault diagnosis and identification on the stator coil of the traction motor.

Before performing fault diagnosis, the insulation sample data (including the dimension-reduced eigenvectors, the motor speed and the motor torque) of the stator coil respectively in an insulation early fault state, in an insulation serious fault state and in an insulation normal state are inputted to the fuzzy clustering model to determine clustering categories. Then, the fuzzy clustering model is corrected based on the insulation sample data of the stator coil. Then, insulation fault diagnosis is performed on the stator coil of the stator coil by using the corrected fuzzy clustering model based on the dimension-reduced eigenvectors, the motor speed and the motor torque which are inputted in real time.

The fuzzy clustering algorithm is a data classification algorithm, and is one of technical means commonly used by those skilled in the art. The specific calculation process may refer to the relevant technical documents, and is not described in detail herein.

In the embodiments of the present disclosure, without adding sensors and performing device modification in a traction system of the train, the traction motor of the train is taken as the object, a predetermined gradient boosting tree model is called based on the fault diagnosis parameters of the bearing of the traction motor to perform fault diagnosis on the bearing of the traction motor, and a predetermined fuzzy clustering model is called based on the insulation fault diagnosis parameters of the stator coil of the traction motor to perform insulation fault diagnosis on the stator coil of the traction motor, thereby reducing the cost of the fault diagnosis of the traction motor.

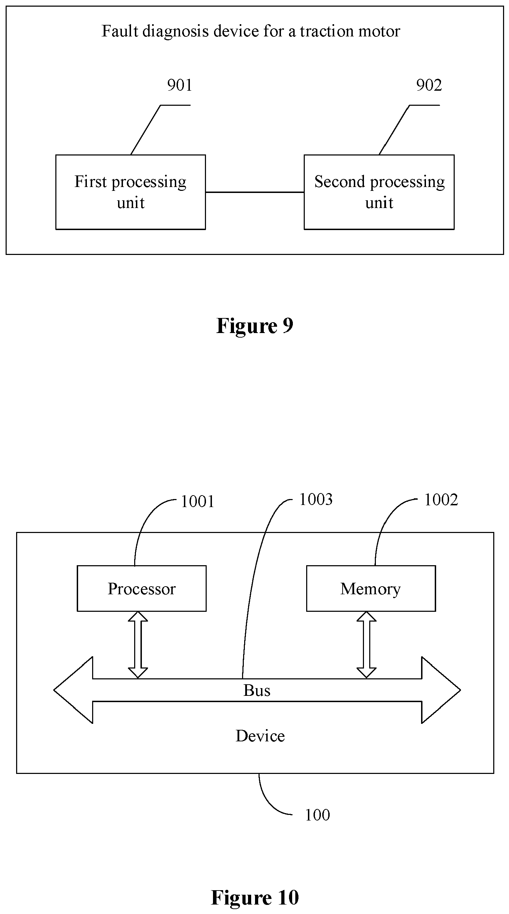

Referring to Figure 9, based on the fault diagnosis method for a traction motor according to the embodiments, a fault diagnosis device for a traction motor is provided according to an embodiment of the present disclosure. The device is applied to a fault diagnosis system for the traction motor. The fault diagnosis device for a traction motor includes a first processing unit 901 and a second processing unit 902.

The first processing unit 901 is configured to call a predetermined gradient boosting tree model and perform fault diagnosis on a bearing with fault diagnosis parameters of the bearing as an input to obtain a fault diagnosis result of the bearing, where the predetermined gradient boosting tree model is constructed based on sample data of the bearing, the sample data of the bearing includes fault diagnosis parameters of the bearing respectively in a normal state, in an outer ring fault state, in an inner ring fault state, in a rolling element fault state and in a cage fault state, the fault diagnosis parameters of the bearing include a fault harmonic pulse spectrum index, a motor speed, a motor torque and a current signal, and the fault harmonic pulse spectrum index indicates a fault state of the bearing of the traction motor.

The second processing unit 902 is configured to call a predetermined fuzzy clustering model and perform insulation fault diagnosis on a stator coil with insulation fault diagnosis parameters of the stator coil as an input to obtain an insulation fault diagnosis result of the stator coil, where the predetermined fuzzy clustering model is constructed based on insulation sample data of the stator coil, the insulation sample data of the stator coil includes insulation fault diagnosis parameters of the stator coil respectively in an insulation early fault state, in an insulation serious fault state and in an insulation normal state, the insulation fault diagnosis parameters of the stator coil include a dimension-reduced eigenvector, the motor speed and the motor torque, and the dimension-reduced eigenvector indicates an insulation fault state of the stator coil of the traction motor.

The fault diagnosis device for a traction motor includes a processor and a memory. The first processing unit and the second processing unit are both stored in the memory as program units. The processor executes the program units stored in the memory to perform corresponding functions.

The processor includes a core, and the core is configured to call a program unit in the memory. The number of the cores may be one or more. Without adding sensors and performing device modification in a traction system of the train, the traction motor of the train is taken as the object, a predetermined gradient boosting tree model is called based on the fault diagnosis parameters of the bearing of the traction motor to perform fault diagnosis on the bearing of the traction motor, and a predetermined fuzzy clustering model is called based on the insulation fault diagnosis parameters of the stator coil of the traction motor to perform insulation fault diagnosis on the stator coil of the traction motor, thereby reducing the cost of the fault diagnosis of the traction motor.

A storage medium is provided according to an embodiment of the present disclosure. The storage medium stores a program. The program, when executed by a processor, causes the processor to perform the fault diagnosis method for a traction motor.

A processor is provided according to an embodiment of the present disclosure. The processor is configured to execute a program to perform the fault diagnosis method for a traction motor.

An electronic device is provided according to an embodiment of the present disclosure. As show in Figure 10, the electronic device 100 includes at least one processor 1001, at least one memory 1002 connected to the processor, and a bus 1003. The processor 1001 communicates with the memory 1002 via the bus 1003. The processor 1001 is configured to call program instructions stored in the memory 1002 to perform the fault diagnosis method for a traction motor.

The electronic device in the present disclosure may be a server, a PC, a PAD, a mobile phone, or the like.

A computer program product is further provided according to an embodiment of the present disclosure. The computer program product, when executed on a data processing device, is applicable to execute a program initialized with the following steps of a method: calling a predetermined gradient boosting tree model, and performing fault diagnosis on a bearing with fault diagnosis parameters of the bearing as an input to obtain a fault diagnosis result of the bearing, where the predetermined gradient boosting tree model is constructed based on sample data of the bearing, the sample data of the bearing includes fault diagnosis parameters of the bearing respectively in a normal state, in an outer ring fault state, in an inner ring fault state, in a rolling element fault state and in a cage fault state, the fault diagnosis parameters of the bearing include a fault harmonic pulse spectrum index, a motor speed, a motor torque and a current signal, and the fault harmonic pulse spectrum index indicates a fault state of the bearing of the traction motor; and calling a predetermined fuzzy clustering model, and performing insulation fault diagnosis on a stator coil with insulation fault diagnosis parameters of the stator coil as an input to obtain an insulation fault diagnosis result of the stator coil, where the predetermined fuzzy clustering model is constructed based on insulation sample data of the stator coil, the insulation sample data of the stator coil includes insulation fault diagnosis parameters of the stator coil respectively in an insulation early fault state, in an insulation serious fault state and in an insulation normal state, the insulation fault diagnosis parameters of the stator coil include a dimension-reduced eigenvector, the motor speed and the motor torque, and the dimension-reduced eigenvector indicates an insulation fault state of the stator coil of the traction motor.

In an embodiment, the fault harmonic pulse spectrum index is obtained by: obtaining the motor speed of the traction motor and the motor torque in a motor control model; respectively performing Fourier transformation on the motor speed and the motor torque to obtain a harmonic component of a harmonic pulse frequency of the bearing; and extracting the fault harmonic pulse spectrum index from the harmonic component of the harmonic pulse frequency of the bearing by using a pulse harmonic spectrum analysis algorithm.

In an embodiment, the dimension-reduced eigenvector is obtained by: obtaining a motor control signal of the traction motor, where the motor control signal includes a voltage signal, the current signal, the motor speed, and the motor torque in a motor control model; and extracting a multi-dimension eigenvector in the motor control signal, and performing dimension reduction on the multi-dimension eigenvector to obtain the dimension-reduced eigenvector, where the multi-dimension eigenvector includes at least two of an insulation fault spectrum feature of the stator coil, a fault feature of an insulation short-circuit Park vector mode spectrum of the stator coil of the traction motor, and an imbalanced feature of the traction motor.

In an embodiment, the extracting a multi-dimension eigenvector in the motor control signal and performing dimension reduction on the multi-dimension eigenvector to obtain the dimension-reduced eigenvector includes: obtaining a frequency composition of the motor control signal, and extracting the insulation fault spectrum feature of the stator coil of an insulation fault harmonic pulse frequency of the stator coil as a first eigenvector; performing fusion analysis on the voltage signal and the current signal to obtain a Park vector mode, performing spectrum analysis on the Park vector mode by using a spectrum analysis algorithm to extract the fault feature of the insulation short-circuit Park vector mode spectrum of the stator coil of the traction motor as a second eigenvector; analyzing imbalanced features of the voltage signal and the current signal, and extracting the imbalanced feature of the traction motor as a third eigenvector; and performing dimension reduction on the first eigenvector, the second eigenvector and the third eigenvector to obtain the dimension-reduced eigenvector.

In an embodiment, the performing dimension reduction on the first eigenvector, the second eigenvector and the third eigenvector by using a principal component analysis algorithm to obtain the dimension-reduced eigenvector includes: constructing a dimension-reduced principal component based on the first eigenvector, the second eigenvector and the third eigenvector; determining a dimension of the dimension-reduced eigenvector based on a contribution rate of the principal component; and calculating a load of the principal component, where the load of the principal component is a dimension-reduced eigenvector of an inter-turn short-circuit fault of the traction motor.

In an embodiment, the predetermined gradient boosting tree model is constructed by: obtaining the sample data of the bearing; and training a gradient boosting tree model based on the sample data of the bearing by using a gradient boosting tree intelligent identification algorithm to construct the predetermined gradient boosting tree model for performing fault diagnosis and identification on the bearing of the traction motor.

In an embodiment, the predetermined fuzzy clustering model is constructed by: obtaining the insulation sample data of the stator coil; and training a fuzzy clustering model based on the insulation sample data of the stator coil by using a fuzzy clustering algorithm to construct the predetermined fuzzy clustering model for performing insulation fault diagnosis and identification on the stator coil of the traction motor.

The present disclosure is described with reference to a flow chart and/or a block diagram of the method, the device (system), and the computer program product according to the embodiments of the present disclosure. It should be understood that each flow and/or block of the flow charts and/or block diagrams and a combination of flows and/or blocks in the flow charts and/or block diagrams may be implemented by computer program instructions. The computer program instructions may be provided to a processor of a general computer, a special purpose computer, an embedded processor or other programmable data processing terminal device to generate a machine, so that instructions executed by the processor of the computer or other programmable data processing terminal device generates an apparatus for realizing functions specified in one or more processes in the flow charts and/or one or more blocks in the block diagrams.

In a typical configuration, the device includes one or more processors (CPUs), a memory, and a bus. The device may further include an input/output interface, a network interface and the like.

The memory may include a non-persistent memory, a random-access memory (RAM), and/or a non-volatile memory in a computer-readable medium, such as a read only memory (ROM) or a flash RAM. The memory includes at least one memory chip. The memory is an example of the computer-readable medium.

The computer-readable medium includes a permanent medium and a non-permanent medium, and a removable medium and a non-removable medium, and information storage may be performed by any method or technology. The information may be computer readable instructions, data structures, program modules, or other data. The computer-readable storage medium includes but is not limited to a phase change random access memory (PRAM), a static random access memory (SRAM), a dynamic random access memory (DRAM), other types of random access memory (RAM), a read only memory (ROM), an electrically erasable programmable read-only memory (EEPROM), a flash memory or other memories, a compact disk read only memory (CD-ROM), a digital video disk (DVD) or other optical memories, a cassette magnetic tape, a disk memory, other magnetic storage devices, any other non-transmission medium or any devices capable of storing information that can be accessed by a computer device. The computer readable storage medium in the present disclosure does not include computer readable transitory media such as a modulated data signal and carrier.

It should be further noted that terms of "include", "comprise" or any other variants are intended to be non-exclusive. Therefore, a process, method, article or device including a series of elements includes not only the elements but also other elements that are not enumerated, or also include the elements inherent for the process, method, article or device. Unless expressively limited otherwise, the statement "comprising (including) one... " does not exclude the case that other similar elements may exist in the process, method, article or device.

Those skilled in the art should understand that the embodiments of the present disclosure may be implemented as methods, systems or computer program products. Therefore, the present disclosure may be implemented by only hardware embodiments, only software embodiments or embodiments combining software with hardware. Alternatively, the present disclosure may be implemented as computer program products implemented on one or more computer available storage mediums (including but not limited to a magnetic disk memory, CD-ROM and an optical memory or the like) including computer available program codes.

## Claims

1.  A fault diagnosis method for a traction motor, applied to a fault diagnosis system for the traction motor, and comprising: calling a predetermined gradient boosting tree model, and performing fault diagnosis on a bearing with fault diagnosis parameters of the bearing as an input to obtain a fault diagnosis result of the bearing (S201), wherein the predetermined gradient boosting tree model is constructed based on sample data of the bearing, the sample data of the bearing comprises fault diagnosis parameters of the bearing respectively in a normal state, in an outer ring fault state, in an inner ring fault state, in a rolling element fault state and in a cage fault state, the fault diagnosis parameters of the bearing comprise a fault harmonic pulse spectrum index, a motor speed, a motor torque and a current signal, and the fault harmonic pulse spectrum index indicates a fault state of the bearing of the traction motor; wherein the fault diagnosis method is **characterised by**:

    calling a predetermined fuzzy clustering model, and performing insulation fault diagnosis on a stator coil with insulation fault diagnosis parameters of the stator coil as an input to obtain an insulation fault diagnosis result of the stator coil (S202), wherein the predetermined fuzzy clustering model is constructed based on insulation sample data of the stator coil, the insulation sample data of the stator coil comprises insulation fault diagnosis parameters of the stator coil respectively in an insulation early fault state, in an insulation serious fault state and in an insulation normal state, the insulation fault diagnosis parameters of the stator coil comprise a dimension-reduced eigenvector, the motor speed and the motor torque, and the dimension-reduced eigenvector indicates an insulation fault state of the stator coil of the traction motor;
    wherein the fault harmonic pulse spectrum index is obtained by:

    obtaining the motor speed of the traction motor and the motor torque in a motor control model (S301);
    respectively performing Fourier transformation on the motor speed and the motor torque to obtain a harmonic component of a harmonic pulse frequency of the bearing (S302); and
    extracting the fault harmonic pulse spectrum index from the harmonic component of the harmonic pulse frequency of the bearing by using a pulse harmonic spectrum analysis algorithm (S303);

    wherein the dimension-reduced eigenvector is obtained by:

    obtaining a motor control signal of the traction motor (S501), wherein the motor control signal comprises a voltage signal, the current signal, the motor speed, and the motor torque in a motor control model; and
    extracting a multi-dimension eigenvector in the motor control signal, and performing dimension reduction on the multi-dimension eigenvector to obtain the dimension-reduced eigenvector, wherein the multi-dimension eigenvector comprises at least two of an insulation fault spectrum feature of the stator coil, a fault feature of an insulation short-circuit Park vector mode spectrum of the stator coil of the traction motor, and an imbalanced feature of the traction motor (S502);

    wherein the extracting a multi-dimension eigenvector in the motor control signal and performing dimension reduction on the multi-dimension eigenvector to obtain the dimension-reduced eigenvector comprises:

    obtaining a frequency composition of the motor control signal, and extracting the insulation fault spectrum feature of the stator coil of an insulation fault harmonic pulse frequency of the stator coil as a first eigenvector (S601);
    performing fusion analysis on the voltage signal and the current signal to obtain a Park vector mode, performing spectrum analysis on the Park vector mode by using a spectrum analysis algorithm to extract the fault feature of the insulation short-circuit Park vector mode spectrum of the stator coil of the traction motor as a second eigenvector (S602);
    analyzing imbalanced features of the voltage signal and the current signal, and extracting the imbalanced feature of the traction motor as a third eigenvector (S603); and
    performing dimension reduction on the first eigenvector, the second eigenvector and the third eigenvector to obtain the dimension-reduced eigenvector (S604); and

wherein the performing dimension reduction on the first eigenvector, the second eigenvector and the third eigenvector by using a principal component analysis algorithm to obtain the dimension-reduced eigenvector comprises:

constructing a dimension-reduced principal component based on the first eigenvector, the second eigenvector and the third eigenvector (S701);
determining a dimension of the dimension-reduced eigenvector based on a contribution rate of the principal component (S702); and
calculating a load of the principal component (S703), wherein the load of the principal component is a dimension-reduced eigenvector of an inter-turn short-circuit fault of the traction motor.

2. The method according to claim 1, wherein the predetermined gradient boosting tree model is constructed by:

obtaining the sample data of the bearing (S401); and
training a gradient boosting tree model based on the sample data of the bearing by using a gradient boosting tree intelligent identification algorithm to construct the predetermined gradient boosting tree model for performing fault diagnosis and identification on the bearing of the traction motor (S402).

3. The method according to claim 1, wherein the predetermined fuzzy clustering model is constructed by:

obtaining the insulation sample data of the stator coil (S801); and
training a fuzzy clustering model based on the insulation sample data of the stator coil by using a fuzzy clustering algorithm to construct the predetermined fuzzy clustering model for performing insulation fault diagnosis and identification on the stator coil of the traction motor (S802).

4. A fault diagnosis device for a traction motor, applied to a fault diagnosis system for the traction motor, and comprising:

a first processing unit (901), configured to call a predetermined gradient boosting tree model and perform fault diagnosis on a bearing with fault diagnosis parameters of the bearing as an input to obtain a fault diagnosis result of the bearing, wherein the predetermined gradient boosting tree model is constructed based on sample data of the bearing, the sample data of the bearing comprises fault diagnosis parameters of the bearing respectively in a normal state, in an outer ring fault state, in an inner ring fault state, in a rolling element fault state and in a cage fault state, the fault diagnosis parameters of the bearing comprise a fault harmonic pulse spectrum index, a motor speed, a motor torque and a current signal, and the fault harmonic pulse spectrum index indicates a fault state of the bearing of the traction motor;
wherein the fault diagnosis device is **characterised by**:

a second processing unit (902), configured to call a predetermined fuzzy clustering model and perform insulation fault diagnosis on a stator coil with insulation fault diagnosis parameters of the stator coil as an input to obtain an insulation fault diagnosis result of the stator coil, wherein the predetermined fuzzy clustering model is constructed based on insulation sample data of the stator coil, the insulation sample data of the stator coil comprises insulation fault diagnosis parameters of the stator coil respectively in an insulation early fault state, in an insulation serious fault state and in an insulation normal state, the insulation fault diagnosis parameters of the stator coil comprise a dimension-reduced eigenvector, the motor speed and the motor torque, and the dimension-reduced eigenvector indicates an insulation fault state of the stator coil of the traction motor;
wherein the first processing unit (901) is further configured to:

obtain the motor speed of the traction motor and the motor torque in a motor control model;
respectively perform Fourier transformation on the motor speed and the motor torque to obtain a harmonic component of a harmonic pulse frequency of the bearing; and
extract the fault harmonic pulse spectrum index from the harmonic component of the harmonic pulse frequency of the bearing by using a pulse harmonic spectrum analysis algorithm;

wherein the second processing unit (902) is further configured to:

obtain a motor control signal of the traction motor, wherein the motor control signal comprises a voltage signal, the current signal, the motor speed, and the motor torque in a motor control model; and extract a multi-dimension eigenvector in the motor control signal, and perform dimension reduction on the multi-dimension eigenvector to obtain the dimension-reduced eigenvector, wherein the multi-dimension eigenvector comprises at least two of an insulation fault spectrum feature of the stator coil, a fault feature of an insulation short-circuit Park vector mode spectrum of the stator coil of the traction motor, and an imbalanced feature of the traction motor;

wherein the multi-dimension eigenvector in the motor control signal is extracted and dimension reduction is performed on the multi-dimension eigenvector to obtain the dimension-reduced eigenvector by:

obtaining a frequency composition of the motor control signal, and extracting the insulation fault spectrum feature of the stator coil of an insulation fault harmonic pulse frequency of the stator coil as a first eigenvector;

performing fusion analysis on the voltage signal and the current signal to obtain a Park vector mode, performing spectrum analysis on the Park vector mode by using a spectrum analysis algorithm to extract the fault feature of the insulation short-circuit Park vector mode spectrum of the stator coil of the traction motor as a second eigenvector;

analyzing imbalanced features of the voltage signal and the current signal, and extracting the imbalanced feature of the traction motor as a third eigenvector; and

performing dimension reduction on the first eigenvector, the second eigenvector and the third eigenvector to obtain the dimension-reduced eigenvector; and

wherein dimension reduction is performed on the first eigenvector, the second eigenvector and the third eigenvector by using a principal component analysis algorithm to obtain the dimension-reduced eigenvector by:

constructing a dimension-reduced principal component based on the first eigenvector, the second eigenvector and the third eigenvector;

determining a dimension of the dimension-reduced eigenvector based on a contribution rate of the principal component; and

calculating a load of the principal component, wherein the load of the principal component is a dimension-reduced eigenvector of an inter-turn short-circuit fault of the traction motor.

5. A storage medium storing a program, wherein the program, when executed, causes a device where the storage medium is located to perform the fault diagnosis method for a traction motor according to any one of claims 1 to 3.

6. An electronic device (100), comprising:

at least one processor (1001);
at least one memory (1002) connected to the processor; and
a bus (1003); wherein
the processor (1001) communicates with the memory (1002) via the bus (1003), and the processor (1001) is configured to call program instructions stored in the memory (1002) to perform the fault diagnosis method for a traction motor according to any one of claims 1 to 3.

## Patentansprüche

1. Verfahren zur Diagnose von Zugmotorfehlern, das an ein Fehlerdiagnosesystem für den Zugmotor angewandt wird, und das umfasst:

Abrufen eines vorbestimmten Gradientenverstärkungs-Baummodells und Ausführen einer Fehlerdiagnose auf einem Lager mit Fehlerdiagnosenparametern des Lagers als Eingabe zum Erhalten von einem Fehlerdiagnosenergebnis des Lagers (S201), wobei das vorbestimmte Gradientenverstärkungs-Baummodell basierend auf Beispieldaten des Lagers aufgebaut wird, die Beispieldaten des Lagers Fehlerdiagnosenparameter des Lagers in einem jeweiligen Normalzustand, einem Außenringfehlerzustand, einem Innenringfehlerzustand, einem Wälzkörperfehlerzustand und einem Lagerkäfigfehlerzustand umfassen, die Fehlerdiagnosenparameter des Lagers einen Fehlerindex des harmonischen Pulsspektrums, eine Motordrehzahl, ein Motordrehmoment und ein Stromsignal umfassen und der Fehlerindex des harmonischen Pulsspektrums einen Fehlerzustand des Lagers des Zugmotors anzeigt, wobei das Fehlerdiagnosenverfahren gekennzeichnet wird durch

Abrufen eines vorbestimmten Fuzzy-Häufungsmodells und Ausführen einer Isolierungsfehlerdiagnose auf einer Statorspule mit Isolierungsfehlerdiagnosenparametern der Statorspule als Eingabe zum Erhalten eines Isolierungsfehlerdiagnosenergebnisses der Statorspule (S202), wobei das vorbestimmte Fuzzy-Häufungsmodell basierend auf Isolierungsbeispieldaten der Statorspule aufgebaut wird, die Isolierungsbeispieldaten der Statorspule Isolierungsfehlerdiagnosenparameter der Statorspule in einem jeweiligen frühen Isolierungsfehlerzustand, einem schwerwiegenden Isolierungsfehlerzustand und einem normalen Isolierungszustand umfassen, wobei die Isolierungsfehlerdiagnosenparameter der Statorspule einen dimensionsreduzierten Eigenvektor, die Motordrehzahl und das Motordrehmoment umfassen und der dimensionsreduzierte Eigenvektor einen Isolierungsfehlerzustand der Statorspule des Zugmotors anzeigt,
wobei der Fehlerindex des harmonischen Pulsspektrums durch:

Erhalten der Motordrehzahl des Zugmotors und des Motordrehmoments in einem Motorsteuerungsmodell (S301),
Ausführen der Fourier-Transformation jeweils auf der Motordrehzahl und dem Motordrehmoment zum Erhalten einer harmonischen Komponente einer harmonischen Pulsfrequenz des Lagers (S302) und
Extrahieren des Fehlerindex des harmonischen Pulsspektrums aus der harmonischen Komponente der harmonischen Pulsfrequenz des Lagers durch Verwendung eines pulsharmonischen Spektralanalysenalgorithmus,
erhalten wird,
wobei der dimensionsreduzierte Eigenvektor durch
Erhalten eines Motorsteuerungssignals des Zugmotors (S501), wobei das Motorsteuerungssignal ein Spannungssignal, das Stromsignal, die Motordrehzahl und das Motordrehmoment in einem Motorsteuerungsmodell umfasst, und Extrahieren eines mehrdimensionalen Eigenvektors im Motorsteuerungssignal und Ausführen einer Dimensionsreduzierung auf dem mehrdimensionalen Eigenvektor zum Erhalten des dimensionsreduzierten Eigenvektors, wobei der mehrdimensionale Eigenvektor wenigstens zwei aus einer Isolierungsfehlerspektrumeigenschaft der Statorspule, einer Fehlereigenschaft eines Isolierungs-Kurzschluss-Parkvektormodespektrums der Statorspule des Zugmotors und einer ungleichmäßigen Eigenschaft des Zugmotors (S502),
wobei das Extrahieren eines mehrdimensionalen Eigenvektors im Motorsteuerungssignal und das Ausführen einer Dimensionsreduzierung auf dem mehrdimensionalen Eigenvektor zum Erhalten des dimensionsreduzierten Eigenvektors umfasst:

Erhalten einer Frequenzzusammenfassung des Motorsteuerungssignals und Extrahieren der Isolierungsfehlerspektrumeigenschaft der Statorspule einer harmonischen Pulsfrequenz des Isolierungsfehlers der Statorspule als erster Eigenvektor (S501),
Ausführen einer Fusionsanalyse auf dem Spannungssignal und dem Stromsignal zum Erhalten eines Parkvektormodes, Ausführen einer Spektralanalyse auf dem Parkvektorkmode durch Anwendung eines Spektralanalysenalgorithmus zum Extrahieren der Fehlereigenschaft des Isolierungs-Kurzschluss-Parkvektormodespektrums der Statorspule des Zugmotors als zweiter Eigenvektor (S602),
Analysieren der ungleichmäßigen Eigenschaften des Spannungssignals und des Stromsignals und Extrahieren der ungleichmäßigen Eigenschaft des Zugmotors als dritter Eigenvektor (S603), und
Ausführen der Dimensionsreduzierung auf dem ersten Eigenvektor, dem zweiten Eigenvektor und dem dritten Eigenvektor zum Erhalten des dimensionsreduzierten Eigenvektors (S604),
erhalten wird,
wobei das Ausführen der Dimensionsreduzierung auf dem ersten Eigenvektor, dem zweiten Eigenvektor und dem dritten Eigenvektor zum Erhalten des dimensionsreduzierten Eigenvektors durch Anwendung eines Analysenalgorithmus einer Hauptkomponente:

Aufbauen einer dimensionsreduzierten Hauptkomponente basierend auf dem ersten Eigenvektor, dem zweiten Eigenvektor und dem dritten Eigenvektor (S701),
Bestimmen einer Dimension des dimensionsreduzierten Eigenvektors basierend auf einem Beitragsanteil der Hauptkomponente (S702) und
Berechnen einer Last der Hauptkomponente (S703), wobei die Last der Hauptkomponente einen dimensionsreduzierten Eigenvektor einer in einem Kurzschlussfehler des Zugmotors stattfindenden Zwischendrehung darstellt, umfasst.

2. Verfahren nach Anspruch 1, wobei das vorbestimmte Gradientenverstärkungs-Baummodell durch

Erhalten der Beispieldaten des Lagers (S401) und
Einlernen eines Gradientenverstärkungs-Baummodells basierend auf den Beispieldaten des Lagers durch Anwendung eines intelligenten Identifizierungsalgorithmus für den Gradientenverstärkungsbaum zum Aufbauen des vorbestimmten Gradientenverstärkungs-Baummodels zur Ausführung einer Fehlerdiagnose und -Identifizierung auf dem Lager des Zugmotors (S402),
aufgebaut wird.

3. Verfahren nach Anspruch 1, wobei das vorbestimmte Fuzzy-Häufungsmodell durch

Erhalten der Isolierungsbeispieldaten der Statorspule (S801) und
Einlernen eines Fuzzy-Häufungsmodells basierend auf dem Isolierungsbeispieldaten der Statorspule durch Anwendung eines Fuzzy-Häufungsalgorithmus zum Aufbauen des vorbestimmten Fuzzy-Häufungsmodells zur Ausführung einer Isolierfehlerdiagnose und -Identifizierung auf der Statorspule des Zugmotors (S802),
aufgebaut wird.

4. Vorrichtung zur Diagnose von Zugmotorfehlern, die an ein Fehlerdiagnosensystem für den Zugmotor angewandt wird, und die umfasst:

eine erste Verarbeitungseinheit (901), die zum Abrufen eines vorbestimmten Gradientenverstärkungs-Baummodells und Ausführen einer Fehlerdiagnose auf einem Lager mit Fehlerdiagnosenparametern des Lagers als Eingabe zum Erhalten von einem Fehlerdiagnosenergebnis des Lagers ausgebildet ist, wobei das vorbestimmte Gradientenverstärkungs-Baummodell basierend auf Beispieldaten des Lagers aufgebaut wird, die Beispieldaten des Lagers Fehlerdiagnosenparameter des Lagers in einem jeweiligen Normalzustand, einem Außenringfehlerzustand, einem Innenringfehlerzustand, einem Wälzkörperfehlerzustand und einem Lagerkäfigfehlerzustand umfassen, die Fehlerdiagnosenparameter des Lagers einen Fehlerindex des harmonischen Pulsspektrums, eine Motordrehzahl, ein Motordrehmoment und ein Stromsignal umfassen und der Fehlerindex des harmonischen Pulsspektrums einen Fehlerzustand des Lagers des Zugmotors anzeigt, wobei die Fehlerdiagnosenvorrichtung gekennzeichnet wird, durch
eine zweite Verarbeitungseinheit (902), die zum Abrufen eines vorbestimmten Fuzzy-Häufungsmodells und Ausführen einer Isolierungsfehlerdiagnose auf einer Statorspule mit Isolierungsfehlerdiagnosenparametern der Statorspule als Eingabe zum Erhalten eines Isolierungsfehlerdiagnosenergebnisses der Statorspule ausgebildet wird, wobei das vorbestimmte Fuzzy-Häufungsmodell basierend auf Isolierungsbeispieldaten der Statorspule aufgebaut wird, die Isolierungsbeispieldaten der Statorspule Isolierungsfehlerdiagnosenparameter der Statorspule in einem jeweiligen frühen Isolierungsfehlerzustand, einem schwerwiegenden Isolierungsfehlerzustand und einem normalen Isolierungszustand, wobei die Isolierungsfehlerdiagnosenparameter der Statorspule einen dimensionsreduzierten Eigenvektor, die Motordrehzahl und das Motordrehmoment umfassen und der dimensionsreduzierte Eigenvektor einen Isolierungsfehlerzustand der Statorspule des Zugmotors anzeigt,
wobei die erste Verarbeitungseinheit (901) weiterhin ausgebildet ist:

zum Erhalten der Motordrehzahl des Zugmotors und des Motordrehmoments in einem Motorsteuerungsmodell,
Ausführen der Fourier-Transformation jeweils auf der Motordrehzahl und dem Motordrehmoment zum Erhalten einer harmonischen Komponente einer harmonischen Pulsfrequenz des Lagers und
Extrahieren des Fehlerindex des harmonischen Pulsspektrums aus der harmonischen Komponente der harmonischen Pulsfrequenz des Lagers durch Verwendung eines pulsharmonischen Spektralanalysenalgorithmus,
wobei die zweite Verarbeitungseinheit (902) weiterhin ausgebildet ist,
zum Erhalten eines Motorsteuerungssignals des Zugmotors, wobei das Motorsteuerungssignal ein Spannungssignal, das Stromsignal, die Motordrehzahl und das Motordrehmoment in einem Motorsteuerungsmodell umfasst, und
Extrahieren eines mehrdimensionalen Eigenvektors im Motorsteuerungssignal und Ausführen einer Dimensionsreduzierung auf dem mehrdimensionalen Eigenvektor zum Erhalten des dimensionsreduzierten Eigenvektors, wobei der mehrdimensionale Eigenvektor wenigstens zwei aus einer Isolierungsfehlerspektrumeigenschaft der Statorspule, einer Fehlereigenschaft eines Isolierungs-Kurzschluss-Parkvektormodespektrums der Statorspule des Zugmotors und einer ungleichmäßigen Eigenschaft des Zugmotors,
wobei der mehrdimensionale Eigenvektor im Motorsteuerungssignal extrahiert und die Dimensionsreduzierung auf dem mehrdimensionalen Eigenvektor zum Erhalten des dimensionsreduzierten Eigenvektors ausgeführt wird:

zum Erhalten einer Frequenzzusammenfassung des Motorsteuerungssignals und Extrahieren der Isolierungsfehlerspektrumeigenschaft der Statorspule einer harmonischen Pulsfrequenz des Isolierungsfehlers der Statorspule als erster Eigenvektor,

Ausführen einer Fusionsanalyse auf dem Spannungssignal und dem Stromsignal zum Erhalten eines Parkvektormodes, Ausführen einer Spektralanalyse auf dem Parkvektorkmode durch Anwendung eines Spektralanalysenalgorithmus zum Extrahieren der Fehlereigenschaft des Isolierungs-Kurzschluss-Parkvektormodespektrums der Statorspule des Zugmotors als zweiter Eigenvektor,

Analysieren der ungleichmäßigen Eigenschaften des Spannungssignals und es Stromsignals und Extrahieren der ungleichmäßigen Eigenschaft des Zugmotors als dritter Eigenvektor, und

Ausführen der Dimensionsreduzierung auf dem ersten Eigenvektor, dem zweiten Eigenvektor und dem dritten Eigenvektor zum Erhalten des dimensionsreduzierten Eigenvektors

wobei die Dimensionsreduzierung auf dem ersten Eigenvektor, dem zweiten Eigenvektor und dem dritten Eigenvektor zum Erhalten des dimensionsreduzierten Eigenvektors durch Anwendung eines Analysenalgorithmus einer Hauptkomponente ausgebildet wird, durch

Aufbauen einer dimensionsreduzierten Hauptkomponente basierend auf dem ersten Eigenvektor, dem zweiten Eigenvektor und dem dritten Eigenvektor Bestimmen einer Dimension des dimensionsreduzierten Eigenvektors basierend auf einem Beitragsanteil der Hauptkomponente und

Berechnen einer Last der Hauptkomponente, wobei die Last der Hauptkomponente einen dimensionsreduzierten Eigenvektor einer in einem Kurzschlussfehler des Zugmotors stattfindenden Zwischendrehung darstellt.

5. Speichermittel zum Speichern eines Programms, wobei das Programm bei seinem Ausführen eine Vorrichtung, auf der sich das Speichermittel befindet, veranlasst, das Verfahren zur Diagnose eines Zugmotorfehlers nach einem der Ansprüchen 1 - 3 auszuführen.

6. Elektronische Vorrichtung (100), umfassend:

mindestens einen Prozessor (1001),
mindestens einen mit dem Prozessor verbundenen Speicher (1002), und
einen Bus (1003), wobei
der Prozessor (1001) über den Bus (1003) mit dem Speicher (1002) in Verbindung steht und der Prozessor (1001) ausgebildet ist, im Speicher (1002) gespeicherte Programmieranweisungen aufzurufen, um das Verfahren zur Diagnose eines Zugmotorfehlers gemäß einem der Ansprüche 1 - 3 auszuführen.

## Revendications

1. Procédé de diagnostic de défaut pour un moteur de traction, appliqué à un système de diagnostic de défaut pour le moteur de traction et comprenant :

l'appel d'un modèle de gradient boosting tree prédéfini et l'exécution du diagnostic de défaut sur un palier avec des paramètres de diagnostic de défaut du palier en guise d'entrée pour obtenir un résultat de diagnostic de défaut du palier (S201), le modèle de gradient boosting tree prédéfini étant construit sur la base de données d'échantillon du palier, les données d'échantillon du palier comprenant des paramètres de diagnostic de défaut du palier respectivement dans un état normal, dans un état de défaut de bague extérieure, dans un état de défaut de bague intérieure, dans un état de défaut d'élément de roulement et dans un état de défaut de cage, les paramètres de diagnostic de défaut du palier comprenant un indice spectral d'impulsion harmonique de défaut, une vitesse de moteur, un couple de moteur et un signal de courant, et l'indice spectral d'impulsion harmonique de défaut indiquant un état de défaut du palier du moteur de traction ; dans lequel le procédé de diagnostic de défaut est **caractérisé par** :

l'appel d'un modèle de partitionnement diffus prédéfini et l'exécution d'un diagnostic de défaut d'isolation sur une bobine de stator avec des paramètres de diagnostic de défaut d'isolation de la bobine de stator en guise d'entrée pour obtenir un résultat de diagnostic de défaut d'isolation de la bobine de stator (S202), le modèle de partitionnement diffus prédéfini étant construit sur la base de données d'échantillon d'isolation de la bobine de stator, les données d'échantillon d'isolation de la bobine de stator comprenant des paramètres de diagnostic de défaut d'isolation de la bobine de stator respectivement dans un état de défaut d'isolation précoce, dans un état de défaut d'isolation grave et dans un état normal d'isolation, les paramètres de diagnostic de défaut d'isolation de la bobine de stator comprenant un vecteur propre de dimension réduite, la vitesse de moteur et le couple de moteur, et le vecteur propre de dimension réduite indiquant un état de défaut d'isolation de la bobine de stator du moteur de traction ;

dans lequel l'indice spectral d'impulsion harmonique de défaut est obtenu par :

l'obtention de la vitesse de moteur du moteur de traction et du couple de moteur dans un modèle de commande de moteur (S301) ;

la réalisation respective d'une transformation de Fourier sur la vitesse de moteur et le couple de moteur pour obtenir une composante harmonique d'une fréquence d'impulsion harmonique du palier (S302) ; et

l'extraction de l'indice spectral d'impulsion harmonique de défaut de la composante harmonique de la fréquence d'impulsion harmonique du palier au moyen d'un algorithme d'analyse du spectre harmonique d'impulsion (S303) ;

dans lequel le vecteur propre de dimension réduite est obtenu par :

l'obtention d'un signal de commande de moteur du moteur de traction (S501), le signal de commande de moteur comprenant un signal de tension, le signal de courant, la vitesse de moteur et le couple de moteur dans un modèle de commande de moteur ; et

l'extraction d'un vecteur propre multidimensionnel dans le signal de commande de moteur et la réalisation de la réduction de dimension sur le vecteur propre multidimensionnel pour obtenir le vecteur propre de dimension réduite, le vecteur propre multidimensionnel comprenant au moins deux éléments parmi une caractéristique de spectre de défaut d'isolation de la bobine de stator, une caractéristique de défaut d'un spectre de mode de vecteur de Park de court-circuit d'isolation de la bobine de stator du moteur de traction et une caractéristique de déséquilibre du moteur de traction (S502) ;

dans lequel l'extraction d'un vecteur propre multidimensionnel dans le signal de commande de moteur et la réalisation de la réduction de dimension sur le vecteur propre multidimensionnel pour obtenir le vecteur propre de dimension réduite comprennent :

l'obtention d'une composition fréquentielle du signal de commande de moteur et l'extraction de la caractéristique de spectre de défaut d'isolation de la bobine de stator d'une fréquence d'impulsion harmonique de défaut d'isolation de la bobine de stator comme premier vecteur propre (S601) ;

la réalisation d'une analyse combinée sur le signal de tension et le signal de courant pour obtenir un mode de vecteur de Park, la réalisation d'une analyse spectrale sur le mode de vecteur de Park au moyen d'un algorithme d'analyse spectrale pour extraire la caractéristique de défaut du spectre de mode de vecteur de Park de court-circuit d'isolation de la bobine de stator du moteur de traction comme deuxième vecteur propre (S602) ;

l'analyse de caractéristiques de déséquilibre du signal de tension et du signal de courant et l'extraction de la caractéristique de déséquilibre du moteur de traction comme troisième vecteur propre (S603) ; et

la réalisation d'une réduction de dimension sur le premier vecteur propre, le deuxième vecteur propre et le troisième vecteur propre pour obtenir le vecteur propre de dimension réduite (S604) ; et

dans lequel la réalisation de la réduction de dimension sur le premier vecteur propre, le deuxième vecteur propre et le troisième vecteur propre au moyen d'un algorithme d'analyse de composante principale pour obtenir le vecteur propre de dimension réduite comprend :

la construction d'une composante principale de dimension réduite sur la base du premier vecteur propre, du deuxième vecteur propre et du troisième vecteur propre (S701) ;

la détermination d'une dimension du vecteur propre de dimension réduite sur la base d'un taux de contribution de la composante principale (S702) ; et

le calcul d'une charge de la composante principale (S703), la charge de la composante principale étant un vecteur propre de dimension réduite d'un défaut de court-circuit entre spires du moteur de traction.

2. Procédé selon la revendication 1, dans lequel le modèle de gradient boosting tree prédéfini est construit par :

l'obtention de données d'échantillon du palier (S401) ; et

l'entraînement d'un modèle de gradient boosting tree sur la base des données d'échantillon du palier au moyen d'un algorithme d'identification intelligent de gradient boosting tree pour construire le modèle de gradient boosting tree prédéfini afin de réaliser le diagnostic et l'identification de défaut sur le palier du moteur de traction (S402).

3. Procédé selon la revendication 1, dans lequel le modèle de partitionnement diffus prédéfini est construit par :

l'obtention des données d'échantillon d'isolation de la bobine de stator (S801) ; et
l'entraînement d'un modèle de partitionnement diffus sur la base des données d'échantillon d'isolation de la bobine de stator au moyen d'un algorithme de partitionnement diffus pour construire le modèle de partitionnement diffus prédéfini afin de réaliser le diagnostic et l'identification de défaut d'isolation sur la bobine de stator du moteur de traction (S802).

4. Dispositif de diagnostic de défaut pour un moteur de traction, appliqué à un système de diagnostic de défaut pour le moteur de traction et comprenant :

une première unité de traitement (901), conçue pour appeler un modèle de gradient boosting tree prédéfini et exécuter un diagnostic de défaut sur un palier avec des paramètres de diagnostic de défaut du palier en guise d'entrée pour obtenir un résultat de diagnostic de défaut du palier, le modèle de gradient boosting tree prédéfini étant construit sur la base de données d'échantillon du palier, les données d'échantillon du palier comprenant des paramètres de diagnostic de défaut du palier respectivement dans un état normal, dans un état de défaut de bague extérieure, dans un état de défaut de bague intérieure, dans un état de défaut d'élément de roulement et dans un état de défaut de cage, les paramètres de diagnostic de défaut du palier comprenant un indice spectral d'impulsion harmonique de défaut, une vitesse de moteur, un couple de moteur et un signal de courant, et l'indice spectral d'impulsion harmonique de défaut indiquant un état de défaut du palier du moteur de traction ; dans lequel le dispositif de diagnostic de défaut est **caractérisé par** :

une deuxième unité de traitement (902) conçue pour appeler un modèle de partitionnement diffus prédéfini et exécuter un diagnostic de défaut d'isolation sur une bobine de stator avec des paramètres de diagnostic de défaut d'isolation de la bobine de stator en guise d'entrée pour obtenir un résultat de diagnostic de défaut d'isolation de la bobine de stator, le modèle de partitionnement diffus prédéfini étant construit sur la base de données d'échantillon d'isolation de la bobine de stator, les données d'échantillon d'isolation de la bobine de stator comprenant des paramètres de diagnostic de défaut d'isolation de la bobine de stator respectivement dans un état de défaut précoce d'isolation, dans un état de défaut sérieux d'isolation et dans un état normal d'isolation, les paramètres de diagnostic de défaut d'isolation de la bobine de stator comprenant un vecteur propre de dimension réduite, la vitesse de moteur et le couple de moteur et le vecteur propre de dimension réduite indiquant un état de défaut d'isolation de la bobine de stator du moteur de traction ;
dans lequel la première unité de traitement (901) est en outre conçue pour :

obtenir la vitesse de moteur du moteur de traction et le couple de moteur dans un modèle de commande de moteur ;
réaliser respectivement une transformation de Fourier sur la vitesse de moteur et le couple de moteur pour obtenir une composante harmonique d'une fréquence d'impulsion harmonique du palier ; et
extraire l'indice spectral d'impulsion harmonique de défaut de la composante harmonique de la fréquence d'impulsion harmonique du palier au moyen d'un algorithme d'analyse du spectre harmonique d'impulsion ;

dans lequel la deuxième unité de traitement (902) est en outre conçue pour :

obtenir un signal de commande de moteur du moteur de traction, le signal de commande de moteur comprenant un signal de tension, le signal de courant, la vitesse de moteur et le couple de moteur dans un modèle de commande de moteur ; et
extraire un vecteur propre multidimensionnel dans le signal de commande de moteur et réaliser une réduction de dimension sur le vecteur propre multidimensionnel pour obtenir le vecteur propre de dimension réduite, le vecteur propre multidimensionnel comprenant au moins deux éléments parmi une caractéristique de spectre de défaut d'isolation de la bobine de stator, une caractéristique de défaut d'un spectre de mode de vecteur de Park de court-circuit d'isolation de la bobine de stator du moteur de traction et une caractéristique de déséquilibre du moteur de traction ;

dans lequel le vecteur propre multidimensionnel dans le signal de commande de moteur est extrait et la réduction de dimension est réalisée sur le vecteur propre multidimensionnel pour obtenir le vecteur propre de dimension réduite par :

l'obtention d'une composition fréquentielle du signal de commande de moteur et l'extraction de la caractéristique de spectre de défaut d'isolation de la bobine de stator d'une fréquence d'impulsion harmonique de défaut d'isolation de la bobine de stator comme premier vecteur propre ;
la réalisation d'une analyse combinée sur le signal de tension et le signal de courant pour obtenir un mode de vecteur de Park, la réalisation d'une analyse spectrale sur le mode de vecteur de Park au moyen d'un algorithme d'analyse spectrale pour extraire la caractéristique de défaut du spectre de mode de vecteur de Park de court-circuit d'isolation de la bobine de stator du moteur de traction comme deuxième vecteur propre ;
l'analyse de caractéristiques de déséquilibre du signal de tension et du signal de courant et l'extraction de la caractéristique de déséquilibre du moteur de traction comme troisième vecteur propre ; et
la réalisation d'une réduction de dimension sur le premier vecteur propre, le deuxième vecteur propre et le troisième vecteur propre pour obtenir le vecteur propre de dimension réduite ; et

dans lequel la réduction de dimension est réalisée sur le premier vecteur propre, le deuxième vecteur propre et le troisième vecteur propre au moyen d'un algorithme d'analyse de composante principale pour obtenir le vecteur propre de dimension réduite par :

la construction d'une composante principale de dimension réduite sur la base du premier vecteur propre, du deuxième vecteur propre et du troisième vecteur propre ;
la détermination d'une dimension du vecteur propre de dimension réduite sur la base d'un taux de contribution de la composante principale ; et
le calcul d'une charge de la composante principale, la charge de la composante principale étant un vecteur propre de dimension réduite d'un défaut de court-circuit entre spires du moteur de traction.

5. Support de stockage stockant un programme, dans lequel le programme, quand il est exécuté, amène un dispositif dans lequel le support de stockage est situé à exécuter le procédé de diagnostic de défaut pour un moteur de traction selon l'une quelconque des revendications 1 à 3.

6. Dispositif électronique (100), comprenant :

au moins un processeur (1001) ;
au moins une mémoire (1002) connectée au processeur ; et
un bus (1003) ; dans lequel
le processeur (1001) communique avec la mémoire (1002) par le biais du bus (1003) et le processeur (1001) est conçu pour appeler des instructions de programme enregistrées dans la mémoire (1002) pour exécuter le procédé de diagnostic de défaut pour un moteur de traction selon l'une quelconque des revendications 1 à 3.

Fault diagnosis system for a traction motor

10　　　　　　　　11　　　　　　　　12

| Acquisition module | Fault diagnosis module | Fault output module |

**Figure 1**

Call a predetermined gradient boosting tree model, and perform fault diagnosis on a bearing with fault diagnosis parameters of the bearing as an input to obtain a fault diagnosis result of the bearing　　S201

Call a predetermined fuzzy clustering model, and perform insulation fault diagnosis on a stator coil with insulation fault diagnosis parameters of the stator coil as an input to obtain an insulation fault diagnosis result of the stator coil　　S202

**Figure 2**

| | |
|---|---|
| Obtain the motor speed of the traction motor and the motor torque in a motor control model | S301 |

↓

| | |
|---|---|
| Respectively perform Fourier transformation on the motor speed and the motor torque to obtain a harmonic component of a harmonic pulse frequency of the bearing | S302 |

↓

| | |
|---|---|
| Extract the fault harmonic pulse spectrum index from the harmonic component of the harmonic pulse frequency of the bearing by using a pulse harmonic spectrum analysis algorithm | S303 |

**Figure 3**

| | |
|---|---|
| Obtain the sample data of the bearing | S401 |

↓

| | |
|---|---|
| Train a gradient boosting tree model based on the sample data of the bearing by using a gradient boosting tree intelligent identification algorithm to construct the predetermined gradient boosting tree model for performing fault diagnosis and identification on the bearing of the traction motor | S402 |

**Figure 4**

Obtain a motor control signal of the traction motor, where the motor control signal includes a voltage signal, a current signal, the motor speed, and the motor torque in a motor control model — S501

Extract a multi-dimension eigenvector in the motor control signal, and perform dimension reduction on the multi-dimension eigenvector to obtain the dimension-reduced eigenvector, where the multi-dimension eigenvector includes at least two of an insulation fault spectrum feature of the stator coil, a fault feature of an insulation short-circuit Park vector mode spectrum of the stator coil of the traction motor, and an imbalanced feature of the traction motor — S502

**Figure 5**

Obtain a frequency composition of the motor control signal, and extract the insulation fault spectrum feature of the stator coil of an insulation fault harmonic pulse frequency of the stator coil as a first eigenvector — S601

Perform fusion analysis on the voltage signal and the current signal to obtain a Park vector mode, perform spectrum analysis on the Park vector mode by using a spectrum analysis algorithm to extract the fault feature of the insulation short-circuit Park vector mode spectrum of the stator coil of the traction motor as a second eigenvector — S602

Analyze imbalanced features of the voltage signal and the current signal, and extract the imbalanced feature of the traction motor as a third eigenvector — S603

Perform dimension reduction on the first eigenvector, the second eigenvector and the third eigenvector to obtain the dimension-reduced eigenvector — S604

**Figure 6**

Construct a dimension-reduced principal component based on the first eigenvector, the second eigenvector and the third eigenvector — S701

Determine a dimension of the dimension-reduced eigenvector based on a contribution rate of the principal component — S702

Calculate a load of the principal component, where the load of the principal component is a dimension-reduced eigenvector of an inter-turn short-circuit fault of the traction motor — S703

**Figure 7**

Obtain the insulation sample data of stator coil — S801

Train a fuzzy clustering model based on the insulation sample data of the stator coil by using a fuzzy clustering algorithm to construct the predetermined fuzzy clustering model for performing insulation fault diagnosis and identification on the stator coil of the traction motor — S802

**Figure 8**

Fault diagnosis device for a traction motor

901

902

First processing unit

Second processing unit

**Figure 9**

1001

1003

1002

Processor

Memory

Bus

Device

100

**Figure 10**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 109061474 A

**Non-patent literature cited in the description**

- An Integrated Model of kNN and GBDT for Fault Diagnosis of Wheel on Railway Vehicle. **KOU LINLIN.** 2018 PROGNOSTICS AND SYSTEM HEALTH MANAGEMENT CONFERENCE (PHM-CHONGQING). IEEE, 26 October 2018

- Fault detection and isolation based on fuzzy-integral fusion approach. **JAFARI HAMIDEH.** IET SCIENCE, MEASUREMENT AND TECHNOLOGY, THE INSTITUTION OF ENGINEERING AND TECHNOLOGY. MICHAEL FARADAY HOUSE, 01 March 2019, vol. 13
- **NYKYRI MIKKO.** *DATA ANALYTICS FOR PREDICTIVE MAINTENANCE IN A PULP MILL-CASE ELECTRIC MOTORS,* 01 January 2018, 1-48